## Europäisches Patentamt
## European Patent Office
## Office européen des brevets

(11) Veröffentlichungsnummer: **0 034 729 B1**

(12) # EUROPÄISCHE PATENTSCHRIFT

(45) Veröffentlichungstag der Patentschrift: **30.10.91**

(51) Int. Cl.5: **H01L 29/36, H01L 21/266, H01L 21/285, H01L 29/812**

(21) Anmeldenummer: **81100732.7**

(22) Anmeldetag: **02.02.81**

(54) Verfahren zur Herstellung einer GaAs-Halbleiteranordnung.

(30) Priorität: **15.02.80 DE 3005733**

(43) Veröffentlichungstag der Anmeldung:
**02.09.81 Patentblatt 81/35**

(45) Bekanntmachung des Hinweises auf die Patenterteilung:
**30.10.91 Patentblatt 91/44**

(84) Benannte Vertragsstaaten:
**DE FR GB**

(56) Entgegenhaltungen:
**EP-A- 0 027 903**
**FR-A- 2 358 751**
**GB-A- 2 005 916**

**IBM TECHNICAL DISCLOSURE BULLETIN, Band 22, Nr. 9, Februar 1980, Seiten 4254-4255, New York, US; F.H. GAENSSLEN et al.: "Fully self-aligned MESFET structure"**

**EXTENDED ABSTRACTS, Band 79-2, 14.-19. Oktober 1979, Seiten 820-822, Fall meeting, Princeton, New Jersey, US; H.M. DARLEY et al.: "Silicon MESFET integrated circuit technology"**

(73) Patentinhaber: **SIEMENS AKTIENGESELL-SCHAFT**
**Wittelsbacherplatz 2**
**W-8000 München 2(DE)**

(72) Erfinder: **Pettenpaul, Ewald Dr.-Ing. Dipl.-Phys.**
**Fasanenstrasse 68 b**
**W-8025 Unterhaching(DE)**
Erfinder: **Huber, Jakob, Dipl.-Phys.**
**Mühlenweg 10 b**
**W-8011 Aying(DE)**
Erfinder: **Weidlich, Herbert Dr. rer. nat. Dipl.-Phys.**
**Hochäckerstrasse 12**
**W-8000 München 83(DE)**

INTERNATIONAL ELECTRON DEVICES MEETING, 3.-5. Dezember 1979, Seiten 493-496, IEEE, New York, US; B.M. WELCH et al.: "Planar high yield GaAs IC processing techniques"

PROCEEDINGS OF THE SEVENTH BIENNIAL CORNELL ELECTRICAL ENGINEERING CONFERENCE, 14.-16. August 1979, Seiten 189-197, Cornell University, Ithaca, IEEE, New York, US; W.J. DEVLIN et al.: "Fet structures on MBE Ge-GaAs using refractory metallization"

PATENT ABSTRACTS OF JAPAN, Band 5, Nr. 171 (E-80) [843], 30. October 1981 & JP-A-56-98 877

APPLIED PHYSICS LETTERS, Band 33, Nr. 7, 1. Oktober 1978, Seiten 651-653, American Institute of Physics, New York, US; P.A. BARNES et al.: "Nonalloyed ohmic contacts to n-GaAs by molecular beam epitaxy"

INTERNATIONAL JOURNAL OF ELECTRONICS, Band 47, Nr. 5, November 1979, Seiten 459-467, London, GB; R.P. GUPTA et al.: "Metallization systems for ohmic contacts to p- and n-type GaAs"

## Beschreibung

Die Erfindung betrifft ein Verfahren zur Herstellung einer Halbleiteranordnung mit einem Halbleiterkörper aus GaAs, bei dem der Halbleiterkörper mit einem ersten Dotierstoff dotiert wird zur Erzeugung einer ersten leitenden Zone, auf der ein sperrender Kontakt entstehen soll, und mit zweiten Dotierstoffen implantiert wird zur Erzeugung einer zweiten leitenden Zone, auf der nichtsperrende Kontakte entstehen sollen, und bei dem mindestens eine Metallisierung zur Erzeugung von sperrenden und nichtsperrenden Kontakten auf den verschiedenen Zonen aufgebracht wird.

Ein derartiges Verfahren geht aus der Veröffentlichung International Electron Devices Meeting Technical Digest, 3.-5. Dezember 1979, Washington, D.C., IEEE, New York 1979, S. 493-496 als bekannt hervor.

Unter "Halbleiterkörper" ist ein insbesondere einkristallines halbleitendes oder halbisolierendes Substrat oder eine sich direkt oder über eine oder mehrere weitere epitaktische halbleitende oder halbisolierende Schichten auf einem Substrat befindende epitaktische Schicht zu verstehen. Weiterhin sind Halbleiteranordnungen, beispielsweise Mikrowellendioden, Feldeffekttransistoren oder integrierte Schaltkreise, in denen Ladungsträger in einer dünnen Schicht (mit einer Dicke in der Größenordnung $1 \mu m$ bis $0,1 \mu m$) mit hoher Leitfähigkeit fließen. Ein Feldeffekttransistor umfaßt dabei beispielsweise ein halbisolierendes GaAs-Substrat, in dem vorzugsweise durch Ionenimplantation dotierte Bereiche erzeugt sind, eine nichtsperrende Source- beziehungsweise Drainelektrode und eine sperrende Gateelektrode.

Bei der Herstellung von Feldeffekttransistoren wurde bisher zunächst eine ohmsche Metallisierung für Source- beziehungsweise Drainelektrode abgeschieden. Anschließend wurde eine Schottkyelektrode für Gate zwischen der Source- und der Drainelektrode mit Hilfe einer Fototechnik justiert und mit einer zweiten Metallisierung und einer Abhebetechnik realisiert. Hierbei geht die Justiergenauigkeit voll in den Abstand Gate-Source ein. Die Veröffentlichung in IBM Technical Disclosure Bulletin, Vol.22, No.9, Februar 1980, S.4254-4255 zeigt das Prinzip einer MESFET-Struktur, die mit zwei Implantationsschritten für Source- und Drainkontakte bzw. den Kanalbereich sowie einem Aufdampfschritt für die Metallisierung hergestellt wird.

Der Erfindung liegt die Aufgabe zugrunde, ein einfaches Verfahren der eingangs genannten Art zu schaffen, das die Herstellung von Halbleiteranordnungen mit Elektrodenabständen im $\mu m$- und sub-$\mu m$-Bereich mit hoher Justiergenauigkeit erlaubt.

Diese Aufgabe wird erfindungsgemäß dadurch gelöst, daß als erster Dotierstoff Te, S, Se oder Si verwendet wird, daß als zweiter Dotierstoff Ge verwendet wird, daß eine einzige aus Cr/Au oder Cr/Au/W/Au bestehende Metallisierung zur Bildung sowohl des sperrenden als auch der nichtsperrenden Kontakte auf den verschiedenen Zonen aufgebracht wird, und daß anschließend ein Temperschritt durchgeführt wird, nach dem auf der ersten leitenden Zone ein sperrender Kontakt und auf der zweiten leitenden Zone nichtsperrende Kontakte entstehen.

Die Erfindung ermöglicht es, beispielsweise Mikrowellenhalbleiterbauelemente herzustellen, die infolge nicht mehr notwendiger Justierung von Steuerelektroden (Gates) eine zunehmende Miniaturisierung ermöglichen, wie zum Beispiel Feldeffekttransistoren mit einer Gatelänge von $0,5 \mu m$ und Source-Gate- beziehungsweise Drain-Gate-Abständen von höchstens $1 \mu m$. Darüber hinaus können auch Leistungsfeldeffekttransistoren durch zahlreiche Parallelschaltung von Einzelbauelementen und integrierte Schaltungen mit höherer Zuverlässigkeit infolge nicht auftretender Justierungsfehler geschaffen werden. Damit werden eine Anhebung der Verstärkung, eine Verminderung der Rauschzahl und eine Erhöhung der Leistung von Mikrowellenbauelementen ermöglicht.

Vorteilhafte Weiterbildungen der Erfindung sind in den Patentansprüchen 2 bis 4 angegeben.

Zur Herstellung von sperrenden und nichtsperrenden Kontakten werden also die Elektrodenbereiche für beispielsweise Source, Drain und Gate mit Hilfe von Fotolackstrukturen definiert; anschließend wird eine Metallisierung (Cr/Au) ganzflächig mit einem Aufdampfvorgang abgeschieden, und mit Hilfe von organischen Lösungsmitteln wird die Metallschicht außerhalb der Elektrodenbereiche abgehoben. Nach dem Legieren entstehen auf Bereichen mit leitenden Schichten unter $5 . 10^{17}$ Dotierungsatomen/cm$^3$ sperrende Kontakte und auf Bereichen mit leitenden Schichten über $10^{18}$ Dotierungsatomen/cm$^3$ nichtsperrende Kontakte. Die durch dieses Verfahren hergestellte Halbleiteranordnung kann zum Beispiel eine Diode, ein Feldeffekttransistor oder ein integrierter Schaltkreis sein.

Durch lokale Implantation von $10^{12}$ bis $10^{14}$ Atomen/cm$^2$ mit beispielsweise Si$^+$ wird für den späteren Kanalbereich nach der Ausheilung von Implantationsschäden eine leitende Schicht von $1 . 10^{15}$ bis $5 . 10^{17}$ Dotierungsatomen/cm$^3$ geschaffen.

An anderer Stelle wird eine zweite lokale Implantation von $10^{14}$ bis $10^{17}$ Atomen/cm$^2$ mit Ge$^+$ ausgeführt, wobei nach der Ausheilung eine zweite leitende Schicht mit über $10^{18}$ Dotierungsatomen/cm$^3$ entsteht.

Zur Herstellung von sperrenden und nichtsperrenden Kontakten wird nur noch eine einzige aus Cr/Au oder Cr/Au/W/Au bestehende Metallschichtenfolge, abgeschieden, wobei auf Bereichen mit der niedrigeren Konzentration sperrende Kontakte, auf Bereichen mit hohen Konzentrationen nichtsperrende Kontakte entstehen.

Der Abstand zwischen sperrenden und nichtsperrenden Kontakten wird allein durch die Abbildungsgenauigkeit bei einer Fototechnik bestimmt. Die Grenze des stark implantierten Bereichs muß zwischen die Konturen der beiden Kontaktarten fallen. Die Herstellung beider Kontaktarten mit nur einer Fototechnik und Metallabscheidung bringt entscheidende Vorteile für die Fototechnik, weil die kritische Abbildung des Gates dabei auf einer vollkommen planen Oberfläche erfolgen kann und weil die Ausbeute, die nach den bisherigen Verfahren durch zwei kritische Metallabhebetechniken bestimmt ist, nach dem erfindungsgemäßen Verfahren nur von einer Abhebetechnik abhängt.

Nachfolgend wird ein Ausführungsbeispiel der Erfindung an Hand der Zeichnung näher erläutert. Es zeigen:

Fig. 1 bis 5    verschiedene Verfahrensschritte zur Herstellung eines Feldeffekttransistors, und

Fig. 6    das Ausgangskennlinienfeld eines nach der Erfindung hergestellten Feldeffekttransistors, wobei auf der Abszisse die Source-Drain-Spannung $U_{SD}$ Und auf der Ordinate der (Drain-Source-) Sättigungsstrom $I_{DS}$ aufgetragen sind und die einzelnen Kurven für Gate-Source-Spannungen erhalten werden, die jeweils um 500 mV erhöht sind.

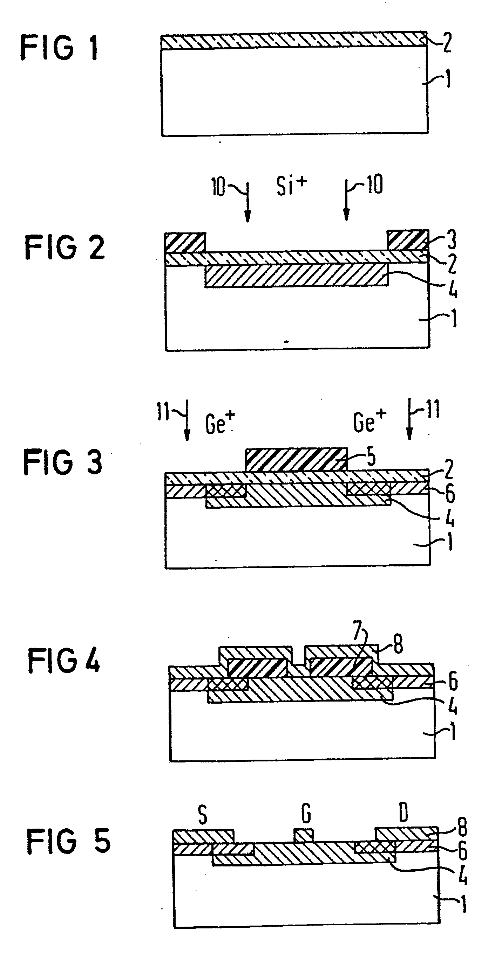

Fig. 1 zeigt ein halbisolierendes GaAs-Substrat 1, in das gegebenenfalls für folgende Fotolackjustierschritte nicht dargestellte Justiermarken hineingeätzt sein können und das anschließend mit einer 0,05 $\mu$m dicken Siliciumnitrid-Passivierungsschicht2 durch Sputtern oder Zerstäuben versehen wird.

Der so präparierte Halbleiterkörper wird mit einer ersten 1 $\mu$m dicken strukturierten Fotolackschicht 3 versehen (Fig. 2), die als Maske bei einer durch Pfeile 10 angedeuteten nachfolgenden ersten Ionenimplantation mit Si$^+$ dient. Diese erste Ionenimplantation wird mit einer Dosis von $6 . 10^{12}$ cm$^{-2}$ Si$^+$-Atomen und einer Energie von 150 keV durchgeführt und ergibt eine lokal leitende Schicht 4 für den späteren Kanalbereich des Feldeffekttransistors nach einer Ausheilung der Gitterdefekte.

Die erste Fotolackschicht 3 wird sodann beispielsweise durch Plasmaveraschen entfernt, und der Halbleiterkörper wird mit einer zweiten, 1 $\mu$m dicken strukturierten Fotolackschicht 5 versehen (Fig. 3), die als Maske bei einer durch Pfeile 11 angedeuteten zweiten Ionenimplantation mit Ge$^+$ dient. Diese zweite Ionenimplantation wird mit einer Dosis von $1 . 10^{15}$ cm$^{-2}$ Ge$^+$-Atomen und einer Energie von 150 keV durchgeführt und ergibt nach Entfernen des Fotolacks und Ausheilung der Gitterdefekte eine lokal leitende Schicht 6 für den späteren Kontaktbereich von Source und Drain des Feldeffekttransistors.

Nach Entfernen der beim Ausheilen verwendeten (nicht gezeigten) Passivierungsschichten durch Ätzen wird der Halbleiterkörper mit einer dritten 1 $\mu$m dicken strukturierten Fotolackschicht 7 versehen, die die Elektrodenbereiche von Source S, Drain D und Gate G in Fenstern festlegt. Es folgt eine ganzflächige Bedampfung mit einer Schicht 8 aus einer Schichtfolge eines 0,027 $\mu$m dicken Cr-Films und eines 0,13 $\mu$m dicken Au-Films (Fig. 4).

Fig. 5 zeigt das zurückbleibende Metallmuster, nachdem durch eine Behandlung in organischen Lösungsmitteln, beispielsweise Aceton, das Metall über der Fotolackschicht 7 abgehoben wurde. Der Halbleiterkörper wird anschließend während etwa 10 min einem Temperaturprozeß bei 400 °C in einer Stickstoffatmosphäre unterzogen. Der Abstand zwischen der Source- und der Drainelektrode S beziehungsweise D beträgt 8 $\mu$m, die Gatelänge in Stromrichtung 1 $\mu$m.

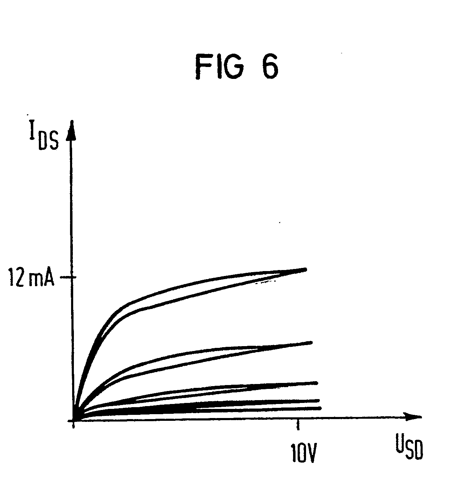

Das Kennlinienfeld eines Feldeffekttransistors (vergleiche Fig. 6), der mit Hilfe des Verfahrens nach der Erfindung hergestellt wurde, zeigt beispielsweise einen Sättigungsstrom von 12 mA, eine Steilheit von 10 mA/V bei 3 V, eine Abschnürspannung von 2,5 V entsprechend einem Reststrom von 50 $\mu$A sowie Source/Drain-, Gate/Source- und Gate/Drain-Widerstände von etwa 100 Ohm und Gate/Source- sowie Gate/Drainspannungen von 15 V.

Galliumarsenid-Feldeffekttransistoren, die bisher durch das Verfahren nach der Erfindung hergestellt sind, zeigen geringere Steilheiten und höhere Widerstände im Vergleich zu einem Feldeffekttransistor herkömmlicher Bauart.

Dies ist insbesondere darauf zurückzuführen, daß die verwendeten Strukturen zu große Source-Gate-Abstände aufweisen. Eine den Toleranzen des neuen Verfahrens angepaßte Struktur mit beispielsweise 1 $\mu$m Source-Gate-Abstand läßt mit dem herkömmlichen Verfahren vergleichbare elektrische Werte mit besserer Gleichmäßigkeit erwarten.

## Patentansprüche

1. Verfahren Zur Herstellung einer Halbleiteranordnung mit einem Halbleiterkörper (1) aus GaAs, bei dem der Halbleiterkörper mit einem ersten Dotierstoff dotiert wird zur Erzeugung einer ersten leitenden Zone (4), auf der ein sperrender Kontakt entstehen soll, und mit zweiten Dotierstoffen implantiert wird zur Erzeugung einer zweiten leitenden Zone (6), auf der nichtsperrende Kontakte entstehen sollen, und bei dem mindestens eine Metallisierung (8) zur Erzeugung von sperrenden und nichtsperrenden Kontakten auf den verschiedenen Zonen (4, 6) aufgebracht wird, **dadurch gekennzeichnet**, daß als erster Dotierstoff Te, S, Se oder Si verwendet wird, daß als zweiter Dotierstoff Ge verwendet wird, daß eine einzige aus Cr/Au oder Cr/Au/W/Au bestehende Metallisierung (8) zur Bildung sowohl des sperrenden als auch der nichtsperrenden Kontakte auf den verschiedenen Zonen (4, 6) aufgebracht wird, und daß anschließend ein Temperschritt durchgeführt wird, nach dem auf der ersten leitenden Zone (4) ein sperrender Kontakt und auf der zweiten leitenden Zone (6) nichtsperrende Kontakte entstehen.

2. Verfahren nach Anspruch 1 bei dem der Halbleiterkörper (1) ein halbisolierendes Substrat ist, **gekennzeichnet** durch

a) Einbringen der ersten leitenden Zone (4) durch lokale Ionenimplantation mit einer Dosis von $10^{12}$ bis $10^{14}$ Atomen/cm$^2$ eines der Elemente Te, S, Se, Si auf einer freigelegten oder mit einer dünnen Passivierungsschicht (2) bedeckten Oberfläche des Substrats (1), so daß die erste Zone (4) 1 x $10^{15}$ bis 5 x $10^{17}$ Dotierungsatome/cm$^3$ enthält,

b) an anderer Stelle Einbringen der zweiten leitenden Zone (6) durch lokale Ionenimplantation mit einer Dosis von $10^{14}$ bis $10^{17}$ Atomen/cm$^2$ des Elements Ge auf einer freigelegten oder mit der dünnen Passivierungsschicht (2) bedeckten Oberfläche des Substrats (1), so daß die zweite Zone (6) über $10^{18}$ Dotierungsatome/cm$^3$ enthält, und

c) Abscheiden der einzigen Metallschicht (8) zur Herstellung von sperrenden und nichtsperrenden Kontakten, wobei auf der ersten Zone (4) ein sperrender Kontakt und auf der zweiten Zone (6) leitende Kontakte erzeugt werden.

3. Verfahren nach Anspruch 1, bei dem der Halbleiterkörper (1) ein Halbleitersubstrat mit einer Dotierungskonzentration über $10^{17}$ Störstellen/cm$^3$ ist, **gekennzeichnet** durch

a) Erzeugen einer 0,5μm bis 5μm dicken ersten leitenden Oberflächenzone (4) mit 1 x $10^{15}$ bis 5 x $10^{17}$ Störstellen/cm$^3$ durch Diffusion oder Ionenimplantation,

b) an anderer Stelle Einbringen der zweiten leitenden Zone (6) durch lokale Ionenimplantation mit einer Dosis von $10^{14}$ bis $10^{17}$

Atomen/cm$^2$ des Elements Ge auf einer freigelegten oder mit einer dünnen Passivierungsschicht (2) bedeckten Oberfläche des Halbleiterkörpers, so daß die zweite Zone (6) über $10^{18}$ Dotierungsatome/cm$^3$ enthält, und

c) Abscheiden der einzigen Metallschicht (8) zur Herstellung von sperrenden und nichtsperrenden Kontakten, wobei auf der ersten Oberflächenzone (4) ein sperrender Kontakt und auf der zweiten Zone (6) leitende Kontakte erzeugt werden.

4. Verfahren nach Anspruch 2 oder 3, **dadurch gekennzeichnet,** daß die Passivierungsschicht (2) eine etwa 0,05μm dicke Siliziumnitridschicht ist.

**Claims**

1. Method for producing a semiconductor arrangement having a semiconductor body (1) composed of GaAs, in which method the semiconductor body is doped with a first dopant to create a first conducting zone (4) on which a blocking contact is to be produced, and is implanted with second dopants to create a second conducting zone (6) on which nonblocking contacts are to be produced, and in which method at least one metallisation (8) is applied to the various zones (4, 6) to create blocking and non-blocking contacts, characterised in that Te, S, Se or Si is used as first dopant, in that Ge is used as second dopant, in that a single metallisation (8) composed of Cr/Au or Cr/Au/W/Au is applied to the various zones (4, 6) to form both the blocking contact and the non-blocking contacts, and in that a heat-treatment step is then carried out, after which a blocking contact is produced on the first conducting zone (4) and non-blocking contacts are produced on the second conducting zone (6).

2. Method according to Claim 1, in which the semiconductor body (1) is a semi-isolating substrate, characterised by

a) introduction of the first conducting zone (4) by local ion implantation with a dose of $10^{12}$ to $10^{14}$ atoms/cm$^2$ of one of the elements Te, S, Se, or Si on an uncovered surface, or a surface covered with a thin passivation layer (2), of the substrate (1) so that the first zone (4) contains 1 x $10^{15}$ to 5 x $10^{17}$ doping atoms/cm$^3$,

b) introduction at another place of the second conducting zone (6) by local ion implantation with a dose of $10^{14}$ to $10^{17}$

atoms/cm$^2$ of the element Ge on an uncovered surface, or a surface covered with the thin passivation layer (2), of the substrate (1) so that the second zone (6) contains more than 10$^{18}$ doping atoms/cm$^3$, and
c) deposition of the single metal layer (8) to produce blocking and non-blocking contacts, a blocking contact being created on the first zone (4) and conducting contacts being created on the second zone (6).

3. Method according to Claim 1, in which the semiconductor body (1) is a semiconductor substrate having a doping concentration of more than 10$^{17}$ impurities/cm$^3$, characterised by
a) creation of a 0.5μm to 5μm thick first conducting surface zone (4) containing 1 x 10$^{15}$ to 5 x 10$^{17}$ impurities/cm$^3$ by diffusion or ion implantation,
b) introduction at another place of the second conducting zone (6) by local ion implantation with a dose of 10$^{14}$ to 10$^{17}$ atoms/cm$^2$ of the element Ge on an uncovered surface, or a surface covered with a thin passivation layer (2), of the semiconductor body so that the second zone (6) contains more than 10$^{18}$ doping atoms/cm$^3$, and
c) deposition of the single metal layer (8) for producing blocking and non-blocking contacts, a blocking contact being created on the first surface zone (4) and conducting contacts being created on the second zone (6).

4. Method according to Claim 2 or 3, characterised in that the passivation layer (2) is a silicon nitride layer about 0.05μm thick.

## Revendications

1. Procédé pour fabriquer un dispositif à semiconducteurs comportant un corps semiconducteur (1) formé de GaAs, selon lequel on dope le corps semiconducteur avec une première substance dopante pour produire une première zone conductrice (4), sur laquelle on doit former un contact bloquant, et on implante dans le corps des secondes substances dopantes pour produire une seconde zone conductrice (6), sur laquelle doivent être formés des contacts non bloquants, et selon lequel on dépose au moins une métallisation (8) servant à produire des contacts bloquants et des contacts non bloquants sur les différentes zones (4, 6), caractérisé par le fait qu'on utilise comme première substance dopante Te, S, Se ou Si, qu'on utilise comme seconde substance dopante Ge, qu'on dépose une seule métallisation (8) formée de Cr/Au ou de Cr/Au/W/Au pour former aussi bien le contact bloquant que les contacts non bloquants sur les différentes zones (4, 6) et qu'ensuite on exécute une étape de recuit, à la suite de laquelle un contact bloquant apparaît sur la première zone conductrice (4) et des contacts non bloquants apparaissent sur la seconde zone conductrice (6).

2. Procédé suivant la revendication 1, selon lequel le corps semiconducteur (1) est un substrat semi-isolant, caractérisé par
a) l'insertion de la première zone conductrice (4), par implantation ionique locale exécutée avec une dose 10$^{12}$ à 10$^{14}$ atomes/cm$^2$ de l'un des éléments Te, S, Se, Si, sur une surface nue du substrat (1) ou une surface de ce substrat recouverte par une mince couche de passivation (2), de manière que la première zone (4) contienne 1 x 10$^{15}$ à 5 x 10$^{17}$ atomes dopants/cm$^3$,
b) l'introduction, en un autre emplacement, de la seconde zone conductrice (6) par implantation ionique locale avec une dose comprise entre 10$^{14}$ et 10$^{17}$ atomes/cm$^2$ de l'élément Ge sur une surface nue du substrat (1) ou sur une surface de ce dernier recouverte par une mince couche de passivation (2) de manière que la seconde zone (6) contienne plus de 10$^{18}$ atomes dopants/cm$^3$, et
c) le dépôt de la couche métallique unique (8) pour fabriquer des contacts bloquants et des contacts non bloquants, un contact bloquant étant formé sur la première zone (4) tandis que des contacts conducteurs sont formés sur la seconde zone (6).

3. Procédé suivant la revendication 1, selon lequel le corps semiconducteur (1) est un substrat semiconducteur possédant une concentration de dopage supérieure à 10$^{17}$ défauts/cm$^3$, caractérisé par
a) la formation d'une première zone superficielle conductrice (4) possédant une épaisseur comprise entre 0,5 μm et 5 μm et possédant 1 x 10$^{15}$ à 5 x 10$^{17}$ défauts/cm$^3$, par diffusion ou implantation ionique,
b) l'introduction, en un autre endroit, de la seconde zone conductrice (6) par implantation ionique locale avec une dose comprise entre 10$^{14}$ et 10$^{17}$ atomes/cm$^2$ de l'élément Ge sur une surface nue du corps semiconducteur ou sur une surface de ce corps recouverte d'une mince couche de passivation (2), de manière que la seconde zone (6) contienne plus de $10^{18}$ atomes dopants/cm$^3$, et

c) le dépôt de la couche métallique unique (8) pour la fabrication de contacts bloquants et non bloquants, un contact bloquant étant formé sur la première zone superficielle (4) tandis que des contacts conducteurs sont formés sur la seconde zone (6).

4. Procédé suivant la revendication 2 ou 3, caractérisé par le fait que la couche de passivation (2) est une couche de nitrure de silicium possédant une épaisseur égale à environ 0,05 $\mu$m.

**FIG 1**

2

1

**FIG 2**

10 ↓   Si⁺   ↓ 10

3
2
4
1

**FIG 3**

11 ↓   Ge⁺   Ge⁺ ↓ 11

5
2
6
4
1

**FIG 4**

7   8
6
4
1

**FIG 5**

S   G   D

8
6
4
1

# FIG 6